# EUROPÄISCHE PATENTSCHRIFT

(11) **EP 0 997 061 B1**
(45) Veröffentlichungstag und Bekanntmachung des Hinweises auf die Patenterteilung: **31.07.2002**
(21) Anmeldenummer: 98952563.9
(22) Anmeldetag: 04.09.1998
(51) Int. Cl.: H05K 3/42, C23C 18/28

(54) **VERFAHREN ZUM METALLISIEREN EINES ELEKTRISCH NICHTLEITENDE OBERFLÄCHENBEREICHE AUFWEISENDEN SUBSTRATS**
METHOD FOR METALLIZATION OF A SUBSTRATE CONTAINING ELECTRIC NON-CONDUCTIVE SURFACE AREAS
PROCEDE PERMETTANT LA METALLISATION D'UN SUBSTRAT PRESENTANT DES ZONES SUPERFICIELLES ELECTRIQUEMENT NON CONDUCTRICES

(30) Priorität: 11.09.1997 DE 19740431
(43) Veröffentlichungstag der Anmeldung: 03.05.2000
(73) Patentinhaber: ATOTECH Deutschland GmbH, 10553 Berlin (DE)
(72) Erfinder: WOLFF, Joachim, D-14195 Berlin (DE); SCHRÖER, Dirk, D-10587 Berlin (DE)
(74) Vertreter: Effert, Bressel und Kollegen
(86) Internationale Anmeldenummer: DE9802694
(87) Internationale Veröffentlichungsnummer: WO9913696

(56) Entgegenhaltungen:
- EP-A- 0 467 199
- EP-A- 0 759 482
- DE-A- 4 412 463
- GB-A- 2 013 722
- US-A- 4 448 811
- US-A- 5 104 687
- US-A- 5 550 006
- PATENT ABSTRACTS OF JAPAN vol. 16, no. 387 (C-0975), 18. August 1992 & JP 04 124281 A (HITACHI CHEM CO), 24. April 1992

## Beschreibung

Die Erfindung betrifft ein Verfahren zum Metallisieren eines elektrisch nichtleitende Oberflächenbereiche aufweisenden Substrats, insbesondere zum Metallisieren von Bohrlochwandungen in mit Kupferoberflächen versehenen Leiterplatten.

Nichtmetallische Oberflächen, insbesondere Wandungen von Löchern in Leiterplatten, werden nach bekannten Methoden durch stromlose Metallisierungsverfahren oder mit Verfahren metallisiert, bei denen ausschließlich elektrolytische Metallisierungsprozesse und keine stromlosen Metallisierungsverfahren eingesetzt werden.

Bei den konventionellen stromlosen Metallisierungsverfahren wird meist als erste leitfähige Schicht eine Kupferschicht auf die nichtleitenden Kunststoffoberflächen und Kupferoberflächen aufgebracht. Hierzu werden die Oberflächen zunächst meist mit einer Palladiumverbindungen enthaltenden Lösung, beispielsweise mit einer Palladiumkolloidlösung, aktiviert. Anschließend werden die Oberflächen mit einem stromlosen Verkupferungsbad behandelt. Üblicherweise wird die Metallschicht in einer Dicke von mindestens 0,1 µm abgeschieden (Günther Herrmann, Handbuch der Leiterplattentechnik, Band 3, Eugen G. Leuze-Verlag, Saulgau, 1993, Seite 72)

Ferner ist auch bekannt, die elektrisch nichtleitenden Oberflächen der Bohrlochwandungen vor der elektrolytischen Beschichtung mit Kupfer mit einer Nikkelschicht stromlos zu metallisieren (Günther Herrmann, Handbuch der Leiterplattentechnik, Band 3, Eugen G. Leuze-Verlag, Saulgau, 1993, Seiten 77 bis 79). Allerdings ist dieses Verfahren für die Bildung einer auch unter thermischer Belastung haftfesten Metallverbindung zwischen der abgeschiedenen Kupfermetallhülse im Bohrloch und der Stirnseite einer Kupferinnenlage nicht ausreichend sicher, da die zwischen der Kupferinnenlage und der abgeschiedenen Kupferschicht gebildete Nickelschicht den Haftverbund schwächt.

Insbesondere bei Verwendung von stromlosen Verkupferungsbädern weisen diese Verfahren allerdings erhebliche Nachteile auf, da große Mengen schwierig zu entsorgender verbrauchter Metallisierungslösungen anfallen und die eingesetzten Chemikalien giftig sind. Ferner ist auch die Überwachung des stromlosen Metallisierungsbades recht schwierig.

Diese Nachteile sollten durch die Entwicklung der sogenannten Direktmetallisierungsverfahren behoben werden, bei denen die Oberflächen ausschließlich mittels elektrolytischer Verfahren metallisiert werden. Es wurden unterschiedliche Verfahren vorgeschlagen. In allen Fällen wird vor der elektrolytischen Verkupferung zunächst eine elektrisch leitfähige Grundschicht auf den Leiterplattenoberflächen erzeugt.

Beispielsweise wird in EP 0 298 298 B1 ein Verfahren beschrieben, bei dem eine katalytische Edelmetallschicht gebildet und diese mittels einer Chalcogenidverbindung in eine elektrisch leitfähige Edelmetallchalcogenidschicht umgewandelt wird. In EP 0 200 398 B1 ist ein anderes Direktmetallisierungsverfahren angegeben, bei dem zur Erzeugung eine für die nachfolgende elektrolytische Metallisierung elektrisch ausreichend leitfähige Grundschicht aus Rußteilchen auf die Substratoberflächen aufgetragen wird.

Ferner wird in DE 39 39 676 C2 ein Verfahren vorgeschlagen, bei dem als elektrisch leitfähige Grundschicht eine intrinsisch leitfähige Polymerschicht, vorzugsweise eine Polypyrrolschicht, gebildet wird.

In US-A 46 83 036 wird ein Direktmetallisierungsverfahren beschrieben, bei dem zunächst Metallkeime auf den nichtleitenden Oberflächen gebildet werden, vorzugsweise Palladiumkeime, und zwar insbesondere durch Verwendung einer Palladiumkolloidlösung, und bei dem anschließend mit einem Verkupferungsbad mit speziellen Additivverbindungen eine Kupferschicht elektrolytisch abgeschieden wird.

Schließlich sind in WO 93/17153 A1 und DE-P 44 12 463 A1 Verfahren offenbart, bei denen auf den nichtleitenden Oberflächen zunächst Schichten von Edelmetallkeimen aus einer Edelmetallkolloidlösung gebildet werden, die mittels eines organischen Schutzkolloids stabilisiert ist. Anschließend werden die bekeimten Oberflächen mit einer Nachtauchlösung behandelt, die Verbindungen aus der Gruppe der Sulfinsäuren, Sulfite, Bisulfite, Thiosulfate, Dithionite, Dithionate und Tetrathionate enthält. Danach wird eine Kupferschicht mit einem elektrolytischen Abscheideverfahren gebildet.

Die genannten Verfahren weisen verschiedene Nachteile auf: Zusammen mit den nichtleitenden Oberflächen werden auch die metallischen Oberflächen einer Leiterplatte mit der elektrisch leitfähigen Grundschicht überzogen. Die zum Teil schwer zugänglichen Stirnflächen der Kupferinnenlagen in den Bohrungen der Leiterplatten müssen jedoch vor einer nachfolgenden Verkupferung völlig frei sein von jeglichen Verunreinigungen, um eine ausreichende Haftfestigkeit zwischen den Innenlagen und der Verkupferungsschicht zu gewährleisten. Dies ist vor allem bei der Bearbeitung von Leiterplatten mit sehr engen Bohrungen ein Problem. Daher müssen die Grundschichten von den Kupferflächen der Leiterplatte vor der elektrolytischen Verkupferung gründlich entfernt werden. Dabei besteht jedoch die Gefahr, daß durch ein ausreichend intensives Behandlungsverfahren zur selektiven Entfernung dieser Grundschichten von den Innenlagen die Grundschicht auch in Nachbarbereichen der Innenlagen geschädigt wird, so daß eine durchgehende flächendeckende Metallisierung nicht mehr möglich ist.

Ferner werden häufig unterschiedliche Leiterplatten-Basismaterialien eingesetzt. Dadurch sind bei einigen Verfahren jeweilige Anpassungen der Behandlungssequenzen und damit eine entsprechende Umstellung der Verfahren erforderlich. Falls mehrere Materialtypen in einer Leiterplatte vorkommen, beispielsweise bei den FR4-Laminaten, die neben bromhaltigem Epoxidharz auch Glasfasergewebe enthalten, können unter Umständen nicht alle Bereiche in den Durchkontaktierungslöchern der Leiterplatten gleich gut vorbehandelt und im weiteren Verfahren metallisiert werden, so daß eventuell sogar nichtmetallisierte Bereiche in der Metallschicht zurückbleiben.

Ein Verfahren mit folgenden Verfahrensschritten:
a) Behandeln des Substrats mit einer Lösung, enthaltend ein Edelmetallkolloid;
b) Behandeln mit einer Ätzlösung, enthaltend säuren wie Schwefelsäure, Salzsäure, Salpetersäure oder Zitronensäure, sowie Wasserstoffperoxid;
c) Erzeugen einer ersten Metallschicht auf den nichtleitenden Oberflächen durch stromlose Metallabscheidung;
d) Erzeugen einer zweiten Metallschicht auf der ersten Metallschicht durch elektrolytische Metallabscheidung ist aus GB-A- 2 013 722 bekannt.

Der vorliegenden Erfindung liegt von daher das Problem zugrunde, die Nachteile der bekannten Verfahren zu vermeiden und insbesondere ein Verfahren zu finden, das eine sichere Metallisierung insbesondere der Bohrlöcher von Leiterplatten ermöglicht, wobei vor allem auch sehr unterschiedliche Basismaterialien ohne wesentliche Änderung des Verfahrens problemlos metallisiert werden können, und bei dem die Nachteile der bekannten stromlosen Metallisierungsverfahren, nämlich die Verwendung von abwassertechnisch schwierig behandelbaren Badkomponenten sowie von giftigen Badbestandteilen, behoben werden.

Dieses Problem wird gelöst durch ein Verfahren gemäß Anspruch 1.

Bevorzugte Ausführungsformen der Erfindung sind in den Unteransprüchen angegeben.

Zur Einstellung der Wasserstoffionenkonzentration enthält die Ätzlösung eine Säure aus der Gruppe Phosphorsäure, Methansulfonsäure oder Essigsäure.

Ein wesentliches Merkmal der Erfindung ist die Kombination eines Edelmetallkolloids zur Bekeimung der Oberflächen mit katalytisch aktiven Keimen und die Verwendung der Ätzlösung mit der angegebenen Konzentration an Wasserstoffionen sowie mit Wasserstoffperoxid. Durch diese Kombination ist es ohne Probleme möglich, die auf den Kupferflächen von Leiterplatten gebildeten Edelmetallkeime wieder vollständig zu entfernen. Gleichzeitig bleiben die auf den nichtleitenden Bereichen des Substrats gebildeten Edelmetallkeime unberührt. Dadurch wird insbesondere eine Nickel- oder eine Palladiumabscheidung auf den Kupferflächen gänzlich verhindert, so daß beim nachfolgenden elektrolytischen Metallisieren eine Metallschicht, beispielsweise eine Kupferschicht, auf die Kupferflächen direkt, das heißt ohne störende Zwischenschichten, abgeschieden werden kann. Hierzu eignet sich ausschließlich die erfindungsgemäße Ätzlösung. Bekannte Ätzlösungen, die anstelle der beanspruchten Bestandteile ein Alkaliperoxodisulfat, Alkalicaroat oder Wasserstoffperoxid in einer schwefelsauren Lösung enthalten, führen zu einem zu starken Angriff der gebildeten Edelmetallkeime und schädigen daher die Bekeimung auch auf den nichtleitenden Oberflächen in unerwünschter Weise.

Mit dem erfindungsgemäßen Verfahren ist es möglich, beliebige Oberflächen problemlos elektrolytisch mit Metall zu beschichten. Beispielsweise können die Wandungen in Löchern von Leiterplatten sogar von aus Polytetrafluorethylen und Faserverstärkungsmaterialien bestehenden Leiterplatten lücken- und porenlos sowie mit hoher Haftfestigkeit beschichtet werden. Mit dem Verfahren ist es auch möglich, beliebige andere Basismaterialien zu bearbeiten, beispielsweise mit Glasfasern verstärktes FR4-Harz, Polyimid-Laminate, Polyamid, Composite-Laminate, wie beispielsweise CEM-1 (Materialkombination aus Epoxidharz/ Hartpapier- und Epoxidharz/Glasfaser-Laminat) oder CEM-3 (Spezialkombination von Polymerharzen und Verstärkungsmaterialien), Cyanatester, Polyetherimid, Polyethersulfon und andere Sondermaterialien. Grundsätzlich ist auch die Metallisierung von anorganischen Substratmaterialien, beispielsweise Keramiken und Gläsern, möglich.

Ferner eignet sich das Verfahren auch zur Beschichtung von Kunststoffkörpern, beispielsweise von aus Kunststoffen hergestellten Sanitärobjekten, Teilen für die Automobilindustrie oder Möbelbeschlägen mit Metall. Derartige Kunststoffkörper weisen keine Metalloberflächen auf und bestehen in der Regel vollständig aus Kunststoff.

Insbesondere eignet sich das Verfahren dazu, die Lochwandungen in Leiterplatten mit einer sehr dichten, porenfreien und thermisch belastbaren Metallschicht zu beschichten, wenn die Löcher mit geringer Bohrqualität hergestellt werden und daher sehr rauhe Lochwände aufweisen.

Ferner kann eine sichere, haftfeste Kupfer/Kupfer-Verbindung an den Ankontaktierungsstellen zwischen den Leiterplatteninnenlagen und einer abgeschiedenen Kupferschicht hergestellt werden, da keine störenden Zwischenschichten zwischen den Kupferschichten entstehen.

Außerdem wird eine Grundschicht mit einer wesentlich höheren elektrischen Leitfähigkeit gebildet als bei den bekannten Direktmetallisierungsverfahren. Dadurch kann die nachfolgende Kupferschicht mit höherer Qualität und besserer Flächenbedeckung elektrolytisch ohne Porenbildung abgeschieden werden.

Wasserstoffperoxid ist in der Ätzlösung in einer Konzentration von 0,5 g/l bis 100 g/l Lösung, vorzugsweise von 3 g/l bis 30 g/l Lösung, und beispielsweise Phosphorsäure in einer Konzentration von 5 g/l bis 200 g/l Lösung, vorzugsweise von 30 g/l bis 90 g/l Lösung, enthalten. Bei höherer Konzentration der beiden Hauptbestandteile muß mit einer Schädigung der Edelmetallbekeimung auf den den Kupferflächen benachbarten Bereichen gerechnet werden. Bei geringerer Konzentration der beiden Hauptbestandteile kann kein befriedigendes Ätzergebnis erreicht werden, so daß sich in diesem Fall teilweise auch auf den Kupferflächen ein Metallfilm bildet. Maßgeblich ist die Kombination der Wasserstoffionenkonzentration und der Wasserstoffperoxidkonzentration in der Lösung.

Die Ätzlösung enthält neben den beanspruchten Bestandteilen gegebenenfalls noch andere chemische Verbindungen, beispielsweise um die Selbstzersetzung von Wasserstoffperoxid zu verhindern. Derartige Verbindungen schließen unter anderem p-Phenolsulfonsäure und Propan-2-ol ein.

Vorzugsweise wird ein Palladiumkolloid als Edelmetallkolloid verwendet. Das Edelmetallkolloid sollte insbesondere als wäßrige, saure Kolloidlösung vorliegen, in der das Palladiumkolloid durch ein organisches Schutzkolloid stabilisiert ist. Eine vorteilhaft einsetzbare Schutzkolloidverbindung ist Poly-4-vinylpyrrolidon. Gut verwendbar sind auch Polyvinylalkohol, Polyvinylpyridin, Polyvinylmethylketon, Polyvinylacetat, Polyacrylsäure und deren Derivate, Polyethylenund Polypropylenglykol, Polyimine sowie Alkyl- und Hydroxyalkylcellulose und deren Copolymere. Darüber hinaus sind auch natürliche Polymere, wie beispielsweise Proteine, Peptide, Polysaccharide, Gelatine, Agar-Agar, einsetzbar.

Palladium ist in dieser Lösung vorzugsweise in einer Konzentration von 20 bis 1000 mg/l Lösung, insbesondere 100 bis 500 mg/l Lösung und vorzugsweise in einer Konzentration von 250 mg/l Lösung, enthalten. Durch Verwendung einer möglichst geringen Palladiumkonzentration wird die Verschleppung des teuren Palladium minimiert. Das Gewichtsverhältnis der Schutzkolloidverbindung zu Palladium beträgt vorzugsweise 1 : 1 bis 100 : 1. Neben Palladium kann die Kolloidlösung ein weiteres Edelmetall, beispielsweise Rhodium, Iridium oder Platin enthalten. Das Gewichtsverhältnis der zusätzlichen Edelmetalle zu Palladium beträgt vorzugsweise 0,01 : 10 bis 1,0 : 10.

Zur Bildung der Kolloidlösung wird ein Reduktionsmittel, insbesondere ein Metallhypophosphitsalz oder Metallphosphitsalz oder deren Säure, eingesetzt. Es sind auch Borhydride, wie Mono-, Di- oder Trialkylborane oder ein Alkalimetallborhydrid, oder andere Reduktionsmittel, beispielsweise Ascorbinsäure, Iso-Ascorbinsäure, Hydrazin, Hydroxylamin oder deren Derivate und Formaldehyd, verwendbar. Die Reduktionsmittel müssen in der Lösung vorzugsweise in einer solchen Menge enthalten sein, daß sich ein negatives elektrochemisches Potential von -170 mV bis -300 mV, gemessen gegen eine Silber/Silberchlorid-Standardelektrode, einstellt.

Die Palladiumkolloidlösung wird nach bekannten Verfahren unter Verwendung einer Palladiumverbindung, die durch das Reduktionsmittel leicht zu metallischem Palladium reduzierbar ist, beispielsweise Palladiumchlorid, Palladiumsulfat oder Palladiumnitrat, hergestellt, indem die Mischung erhitzt wird. Die Kolloidlösung wird durch Zugabe des Reduktionsmittels zur Lösung gebildet. Dabei wird Palladium zu Palladiummetallkeimen reduziert und die Koagulation der Keime durch die Anwesenheit der Schutzkolloidverbindungen verhindert. Die Lösung soll sauer sein, um die Ausfällung von Hydroxiden zu vermeiden. Bevorzugt ist ein Bereich von pH 1 bis 3 und insbesondere von pH 1,2 bis 2,0. Dadurch wird eine gute Adsorption der Palladiumkeime an den Substratoberflächen erreicht bei gleichzeitig ausreichender Stabilität der Kolloidlösung gegen das Ausflocken von Palladium.

Zur Behandlung des Substrats wird die Kolloidlösung auf eine Temperatur oberhalb von Raumtemperatur, beispielsweise auf 40°C, erwärmt.

Gemäß Verfahrensschritt c) wird eine erste Grundmetallschicht ausschließlich auf den nichtleitenden Bereichen des Substrats gebildet. Diese Metallschicht wird in geringer Dicke abgeschieden. Dadurch werden die wesentlichen Nachteile bekannter Verfahren vermieden. Die Dicke der ersten Metallschicht muß allerdings ausreichen, um eine so hohe elektrische Leitfähigkeit zu erzeugen, daß die nachfolgende elektrolytische Metallisierung problemlos durchgeführt werden kann.

Diese elektrisch. leitfähige Grundschicht wird durch Abscheidung einer sehr dünnen Nickel-, Kobalt-, Kupfer- oder Palladiumschicht oder einer Schicht aus einer Legierung dieser Metalle erreicht. Die für die nachfolgende elektrolytische Metallisierung erforderliche elektrische Leitfähigkeit wird nicht bereits durch die Bekeimung mit dem Edelmetallkolloid erreicht. Vielmehr dient die Bekeimung lediglich dazu, eine katalytisch wirksame Grundlage für die nachfolgende Metallisierung zu bilden.

Vorzugsweise wird eine Nickelschicht als erste Metallschicht abgeschieden. Reine Nickelschichten können mit Hydrazin als Reduktionsmittel abgeschieden werden. Kobaltschichten und deren Legierungen werden unter ähnlichen Bedingungen wie Nickelschichten oder deren Legierungen abgeschieden. Kupferschichten können mit Hypophosphit oder mit dem üblicherweise eingesetzten Formaldehyd als Reduktionsmittel gebildet werden. Zur Abscheidung von Palladium können verschiedene Reduktionsmittel eingesetzt werden, beispielsweise die zur Abscheidung der anderen Metalle ebenfalls verwendbaren Verbindungen. Darüber hinaus sind für die Palladiumabscheidung insbesondere Ameisensäure und deren Derivate gut geeignet.

Durch Bildung von Nickel- oder Nickellegierungsschichten oder der entsprechenden Kobaltschichten werden die Nachteile der schwierigen Überwachung und Instandhaltung der Abscheidelösungen behoben. Außerdem entstehen in diesem Falle die bei Verwendung von stromlosen Kupferbädern entstehenden Probleme wegen der schwierig zu entsorgenden Verkupferungslösungen, die auch giftige Badbestandteile enthalten, beispielsweise Formaldehyd, nicht. Die in stromlosen Nickelbädern verwendeten Komplexbildner, beispielsweise Hydroxycarbonsäuren, vorzugsweise Äpfelsäure, Milchsäure, Citronensäure, Bernsteinsäure und Itaconsäure, sind biologisch relativ leicht abbaubar, so daß diese aus den verbrauchten Bädern bei der Abwasserbehandlung nicht oder nicht vollständig entfernt werden müssen.

Ferner ist das zumindest für die Bildung einer Nickel/Phosphor-Legierungsschicht eingesetzte Reduktionsmittel Hypophosphit nicht flüchtig und nur wenig toxisch, so daß sich nur geringe Anforderungen an den Arbeitsschutz ergeben. Dasselbe gilt auch für ein Palladinierungsbad mit Hydroxycarbonsäuren als Komplexbildnern und Ameisensäure oder deren Derivaten als Reduktionsmittel.

Ein weiterer Vorteil der insbesondere mit einer Nickel-, Nickellegierungs-, Kobalt- oder Kobaltlegierungsschicht, mit einer Schicht aus deren Legierungen oder mit einer Palladiumschicht metallisierten Leiterplatte besteht darin, daß sich diese Metalle auf den von Edelmetallkeimen befreiten Kupferflächen der Leiterplatte überhaupt nicht abscheiden lassen. Daher wird die erste Schicht aus diesen Metallen nur in den Bereichen abgeschieden, in denen sie zur sicheren Bildung einer elektrisch leitfähigen Grundschicht unbedingt erforderlich ist. Die elektrolytisch abgeschiedene Kupferschicht wird unmittelbar auf den Kupferflächen gebildet, so daß sich eine innige Verbindung der Metalle ergibt. Diese Verbindung ist auch gegen starke thermische Belastungen sehr unempfindlich. Besonders durch die Verwendung dieser Metalle als erster Metallschicht wird damit in Kombination mit den erfindungemäßen Verfahrensschritten a) und b) eine selektive Metallisierung ausschließlich in den elektrisch nichtleitenden Bereichen ermöglicht, ohne daß vorhandene metallische Bereiche mit Metall belegt werden. Eine selektive Beschichtung gelingt grundsätzlich auch durch eine erste Beschichtung mit anderen Metallen, beispielsweise Kupfer; durch Abscheidung der vorgenannten bevorzugten Metalle gelingt die selektive Beschichtung jedoch leichter.

Für die Durchführung des Verfahrens werden die Löcher im Substrat gegebenenfalls mit einer Reinigungslösung vorbehandelt. Bevorzugt wird eine alkalische Permanganatlösung, mit der beim Bohren entstandene Harzverschmierungen auf den Kupferflächen in den Bohrungen beseitigt werden. Zur besseren Entfernung der Harzverschmierungen werden die Lochwandungen zunächst in einem hierfür üblichen organischen Quellmittel angequollen und danach geätzt. Nach Abschluß des Reinigungsprozesses wird entstandener Braunstein durch ein Reduktionsmittel entfernt. Natürlich sind grundsätzlich auch andere übliche Ätzlösungen einsetzbar, beispielsweise konzentrierte Schwefelsäure oder Chromsäure enthaltende Lösungen. Ferner können die Harzverschmierungen auch mittels eines Plasmaätzprozesses entfernt werden. Die Substratoberflächen können auch zuerst mit einer Netzmittel enthaltenden Lösung behandelt werden.

Danach wird das Substrat zunächst mit einer Konditionierlösung in Kontakt gebracht. Diese Konditionierlösungen enthalten vorzugsweise mindestens eine Polyelektrolytverbindung oder quaternäre, vorzugsweise polyquaternäre Verbindungen. Als Polyelektrolytverbindungen sind insbesondere quaternisierte Polyvinylimidazole geeignet, Zusätzlich kann die Lösung auch Netzmittel und gegebenenfalls einen Komplexbildner, beispielsweise Triethanolamin, enthalten, um die Lochwandungen zu reinigen. Zur Behandlung wird vorzugsweise eine Temperatur von 35 bis 60°C in der Konditionierlösung eingestellt.

Vor der Behandlung mit der Edelmetallkolloidlösung wird das Substrat vorzugsweise mit einer Lösung in Kontakt gebracht, die die Kolloidlösung schützen soll (Vortauchlösung). Diese Lösung kann beispielsweise das in der Kolloidlösung enthaltende Reduktionsmittel enthalten, um durch Verschleppung von Lösungsbestandteilen aus dieser Lösung in die Kolloidlösung den Verlust durch Verschleppung aus der Kolloidlösung heraus zu kompensieren. Alternativ oder Zusätzlich können auch Säuren enthalten sein, beispielsweise Phosphorsäure.

Zur elektrolytischen Metallisierung wird insbesondere ein handelsübliches schwefelsaures Verkupferungsbad verwendet. Anstelle dieses Bades kann auch ein anderes Bad zur Kupferabscheidung oder ein Bad zur elektrolytischen Abscheidung eines anderen Metalls, beispielsweise von Nickel, eines Edelmetalls oder von Zinn oder einer Zinn/Blei-Legierung, verwendet werden.

Zwischen den beschriebenen Behandlungsstufen in den einzelnen Bädern werden die Substrate üblicherweise gespült, um Behandlungslösung von den Oberflächen zu entfernen und die Verschleppung der Lösungen in nachfolgende Behandlungsbäder zu minimieren. Dies gilt nicht für die Behandlungsfolge von der Vortauchlösung zur Kolloidlösung.

Die Leiterplatten können in herkömmlichen Anlagen behandelt werden, wobei die Leiterplatten meist in vertikaler Ausrichtung in die Behandlungsbäder eingetaucht werden. In einer anderen bevorzugten Ausführungsform werden die Leiterplatten in vertikaler oder horizontaler Lage gehalten und mit einem eigens hierfür vorgesehenen Transportsystem in horizontaler Richtung durch eine Behandlungsanlage hindurchtransportiert. Dabei werden die Leiterplatten nacheinander in verschiedenen Behandlungspositionen mit unterschiedlichen Behandlungslösungen in Kontakt gebracht. Die Lösungen werden von unten oder von oben oder von beiden Seiten an die Leiterplatten geschwallt, gesprüht oder gespritzt, oder die Leiterplatten tauchen in ein im wesentlichen ruhendes Bad ein und werden durch dieses hindurchgeführt. Zur besseren Durchströmung der Löcher können auch Saugdüsen vorgesehen sein, denen Schwalldüsen auf der anderen Seite der Leiterplatten gegenüber angeordnet sind.

### Zur weiteren Erläuterung der Erfindung dienen die nachfolgenden Beispiele:

### Beispiele 1 bis 7:

Ein gebohrtes Leiterplattenmaterial mit zwei Kupferinnenlagen aus einem Epoxidharz/Glasfaser-Laminat (FR4-Laminat) wird zunächst mit einem üblichen Permanganat-Verfahren zur Entfernung von Harzverschmierungen an den Wänden der Bohrungen behandelt.

Danach wird das Material mit dem erfindungsgemäßen Verfahren in einer Horizontalanlage durchkontaktiert, durch die die Leiterplatten in horizontaler Lage und horizontaler Richtung transportiert und dabei mit den Behandlungslösungen in Kontakt gebracht werden (es werden jeweils wäßrige Lösungen der angegebenen Stoffe angewendet):

| | Temp. [°C] | Beh.zeit [Sek.] |
|---|---|---|
| 1. Konditionieren (Neopact UX^{*)}) | 50 | 60 |
| 2. Vortauchen (Phosphorsäure) | 30 | 30 |
| 3. Aktivieren (Pd-Kolloid mit 4-Polyvinylpyrrolidon als Schutzkolloid und Natriumhypophosphit als Reduktionsmittel) | 50 | 60 |
| 4. Behandeln mit der Ätzlösung | 35 | 60 |
| 5. Bilden der ersten Metallschicht | 50 | 60 |
| 6. Verkupfern mit einem schwefelsauren Verkupferungsbad | | |

| | | |
|---|---|---|
| ^{*)} Neopact UX ist ein Produkt der Firma Atotech Deutschland GmbH, DE | | |

Es wurde jeweils eine Ätzlösung mit folgender Zusammensetzung verwendet:

| | |
|---|---|
| Phosphorsäure, 85 Gew.-% | 7 Gewichtsteile |
| Wasserstoffperoxid, 35 Gew.-% | 3 Gewichtsteile |
| 2-Propanol | 5 Gewichtsteile |
| Wasser, vollentsalzt | 85 Gewichtsteile |

Es wurden die folgenden Bäder für die erste Metallschicht verwendet:

| Bad 1: | |
|---|---|
| NiSO₄·6 H₂O | 0,8 Gewichtsteile |
| NaH₂PO₂·H₂O | 2,3 Gewichtsteile |
| Citronensäure·H₂O | 1,5 Gewichtsteile |
| NH₃, 25 Gew.-%ig | 1,6 Gewichtsteile |
| H₃BO₃ | 0,6 Gewichtsteile |
| H₂O | 93,2 Gewichtsteile |

| Bad 2: | |
|---|---|
| NiSO₄·6 H₂O | 1,5 Gewichtsteile |
| NaH₂PO₂·H₂O | 1,2 Gewichtsteile |
| Kalium-Natrium-Tartrat-4 H₂O | 2,5 Gewichtsteile |
| NaOH | 0,3 Gewichtsteile |
| H₂O | 94,5 Gewichtsteile |

| Bad 3: | |
|---|---|
| NiCl₂·4 H₂O | 1,4 Gewichtsteile |
| NaBH₄ | 0,3 Gewichtsteile |
| Ethylendiamin | 4 Gewichtsteile |
| NaOH | 4 Gewichtsteile |
| H₂O | 90,3 Gewichtsteile |

| Bad 4: | |
|---|---|
| CuSO₄·5 H₂O | 1 Gewichtsteil |
| NaH₂PO₂·H₂O | 2 Gewichtsteile |
| Citronensäure·H₂O | 3 Gewichtsteile |
| NaOH | 0,7 Gewichtsteile |
| H₂O | 93,3 Gewichtsteile |

| Bad 5: | |
|---|---|
| CuSO₄·5 H₂O | 0,8 Gewichtsteile |
| Kalium-Natrium-Tartrat·4 H₂O | 4,0 Gewichtsteile |
| NaH₂PO₂·H₂O | 2,0 Gewichtsteile |
| Na₂CO₃ | 1,0 Gewichtsteile |
| H₂O | 92,2 Gewichtsteile |

| Bad 6: | |
|---|---|
| PdCl₂ | 0,5 Gewichtsteile |
| Dimethylaminoboran | 0,2 Gewichtsteile |
| Ethylendiamintetraessigsäure | 1,9 Gewichtsteile |
| NaOH | 0,7 Gewichtsteile |
| H₂O | 96,7 Gewichtsteile |

| Bad 7: | |
|---|---|
| CoSO₄ | 0,7 Gewichtsteile |
| NaH₂PO₂·H₂O | 1 Gewichtsteil |
| Citronensäure·H₂O | 2,4 Gewichtsteile |
| NaOH | 0,8 Gewichtsteile |
| H₂O | 95,1 Gewichtsteile |

Bereits nach der ersten stromlosen Metallisierung mit diesen Bädern konnten gleichmäßig geschlossene Metallschichten in den Bohrungen festgestellt werden.

Nach der anschließenden Verkupferung in einem handelsüblichen schwefelsauren Kupferbad wurde eine dichte, geschlossene und porenfreie, 20 µm dicke Metallschicht auf der gesamten Leiterplattenoberfläche einschließlich der Bohrlochwandungen erhalten. Die Leiterplatten wurden 5 mal je 10 Sekunden lang in ein 288 °C heißes Lötbad eingetaucht. Sowohl nach dem äußeren Anschein als auch nach mikroskopischer Untersuchung der metallisierten Leiterplatte in einem Querschliff konnten Abhebungen der Kupferschicht vom Grundmaterial nicht gefunden werden. Außerdem waren auch keine Fehler im Bereich der Ankontaktierungen zwischen den Kupferinnenlagen und dem aufgebrachten Metall feststellbar.

### Beispiele 8 bis 28:

Die vorgenannten Versuche wurden wiederholt. Jedoch wurden jeweils andere Ätzlösungen eingesetzt. Die Zusammensetzungen dieser Ätzlösungen sind nachfolgend angegeben:

| Ätzbad 2: | |
|---|---|
| Eisessig | 8 Gewichtsteile |
| Wasserstoffperoxid, 35 Gew.-% | 6 Gewichtsteile |
| p-Phenolsulfonsäure | 0,1 Gewichtsteile |
| Wasser, vollentsalzt | 85,9 Gewichtsteile |

| Ätzbad 3: | |
|---|---|
| Eisessig | 5 Gewichtsteile |
| Wasserstoffperoxid, 35 Gew.-% | 4 Gewichtsteile |
| 2-Propanol | 5 Gewichtsteile |
| Wasser, vollentsalzt | 86 Gewichtsteile |

| Ätzbad 4: | |
|---|---|
| Methansulfonsäure | 5 Gewichtsteile |
| Wasserstoffperoxid, 35 Gew.-% | 4 Gewichtsteile |
| 2-Propanol | 5 Gewichtsteile |
| Wasser, vollentsalzt | 86 Gewichtsteile |

Es wurden wiederum dieselben guten Ergebnisse wie in den Beispielen 1 bis 7 erhalten.

## Patentansprüche

1. Verfahren zum Metallisieren eines elektrisch nichtleitende Oberflächenbereiche aufweisenden Substrats mit folgenden Verfahrensschritten:
a. Behandeln des Substrats mit einer Lösung, enthaltend ein Edelmetallkolloid;
b. Behandeln mit einer Ätzlösung, enthaltend mindestens eine Säure aus der Gruppe Phosphorsäure, Methansulfonsäure und Essigsäure zur Einstellung einer Wasserstoffionenk konzentration von höchstens 0,5 Mol/kg Lösung und Wasserstoffperoxid in einer Konzentration von 0,5 g/l bis 100 g/l Lösung;
c. Erzeugen einer ersten Metallschicht auf den nichtleitenden Oberflächen bereichen durch stromlose Metallabscheidung;
d. Erzeugen einer zweiten Metallschicht auf der ersten Metallschicht durch elektrolytische Metallabscheidung.

2. Verfahren nach einem der vorstehenden Ansprüche, **dadurch gekennzeichnet, daß** ein Palladiumkolloid als Edelmetallkolloid verwendet wird.

3. Verfahren nach einem der vorstehenden Ansprüche, **dadurch gekennzeichnet, daß** als Lösung in Verfahrensschritt a) eine mit einem organischen Schutzkolloid stabilisierte wäßrige, saure Kolloidlösung eingesetzt wird.

4. Verfahren nach einem der vorstehenden Ansprüche, **dadurch gekennzeichnet, daß** als erste Metallschicht eine Nickel-, Kobalt-, Kupfer- oder Palladiumschicht oder eine Schicht einer Legierung dieser Metalle abgeschieden wird.

5. Verfahren nach einem der vorstehenden Ansprüche, **dadurch gekennzeichnet, daß** als erste Metallschicht eine Nickelschicht oder eine Nickellegierungsschicht abgeschieden wird.

6. Verfahren nach einem der vorstehenden Ansprüche, **dadurch gekennzeichnet, daß** das Substrat vor der Behandlung mit der Palladiumkolloidlösung mit einer ein Polyelektrolyt oder eine quaternäre Verbindung enthaltenden Konditionierlösung behandelt wird.

7. Anwendung des Verfahrens nach einem der Ansprüche 1 bis 6 zum Metallisieren von Bohrlochwandungen in mit Kupferoberflächen versehenen Leiterplatten.

8. Anwendung nach Anspruch 7; **dadurch gekennzeichnet, daß** die Leiterplatten in horizontaler Richtung durch eine geeignete Behandlungsanlage hindurchtransportiert werden und dabei nacheinander in verschiedenen Behandlungspositionen mit unterschiedlichen Behandlungslösungen in Kontakt gebracht werden.

## Claims

1. Method for metal plating of a substrate which has electrically non-conductive surface regions, having the following method steps:
a) treatment of the substrate with a solution containing a noble metal colloid;
b) treatment with an etching solution containing at least one acid from the group phosphoric acid, methanesulfonic acid and acetic acid in order to set a hydrogen ion concentration of at most 0.5 mol/kg of solution and hydrogen peroxide in a concentration of 0.5 g/l to 100 g/l of solution;
c) production of a first metal layer on the non-conductive surface regions by currentless metal deposition;
d) production of a second metal layer on the first metal layer by electrolytic metal deposition.

2. Method according to one of the preceding claims, **characterised in that** a palladium colloid is used as noble metal colloid.

3. Method according to one of the preceding claims, **characterised in that** an aqueous acidic colloid solution, which is stabilised with an organic protective colloid, is used as the solution in method step a).

4. Method according to one of the preceding claims, **characterised in that** a nickel, cobalt, copper or palladium layer or a layer of an alloy of these metals is deposited as the first metal layer.

5. Method according to one of the preceding claims, **characterised in that** a nickel layer or a nickel alloy layer is deposited as the first metal layer.

6. Method according to one of the preceding claims, **characterised in that**, before the treatment with the palladium colloid solution, the substrate is treated with a conditioning solution which contains a polyelectrolyte or a quaternary compound.

7. Application of the method according to one of the claims 1 to 6 for metal plating boring walls in printed circuit boards which are provided with copper surfaces.

8. Application according to claim 7, **characterised in that** the printed circuit boards are transported through a suitable treatment plant in the horizontal direction and thereby are brought into contact successively in various treatment positions with various treatment solutions.

## Revendications

1. Procédé permettant la métallisation d'un substrat présentant des zones superficielles électriquement conductrices avec les étapes suivantes :
a. traitement du substrat avec une solution contenant un colloïde de métaux précieux ;
b. traitement avec une solution d'attaque contenant au moins un acide provenant du groupe de l'acide phosphorique, l'acide méthanesulfonique et l'acide acétique pour régler une concentration en ions hydrogène d'au maximum 0,5 moles/kg de solution et le peroxyde d'hydrogène en une concentration de 0,5 g/l à 100 g/l de solution;
c. production d'une première couche métallique sur des zones superficielles par dépôt métallique autocatalytique ;
d. production d'une deuxième couche métallique sur la première couche métallique par dépôt métallique électrolytique.

2. Procédé selon l'une des revendications précédentes, **caractérisé en ce que** l'on utilise un colloïde de palladium comme colloïde de métaux précieux.

3. Procédé selon l'une des revendications précédentes, **caractérisé en ce que** l'on met en oeuvre comme solution dans l'étape a) une solution de colloïde acide aqueuse stabilisée avec un colloïde protecteur organique.

4. Procédé selon l'une des revendications précédentes, **caractérisé en ce que** l'on dépose comme première couche métallique une couche de nickel, de cobalt, de cuivre ou de palladium ou une couche d'un alliage de ces métaux.

5. Procédé selon l'une des revendications précédentes, **caractérisé en ce que** l'on dépose comme première couche métallique une couche de nickel ou une couche d'alliage de nickel.

6. Procédé selon l'une des revendications précédentes, **caractérisé en ce que** l'on traite le substrat avant le traitement à la solution de colloïde de palladium avec une solution de conditionnement contenant un polyélectrolyte ou un composé quaternaire.

7. Utilisation du procédé selon l'une des revendications 1 à 6 permettant la métallisation de parois de trous dans des cartes de circuits imprimés dotées de surfaces en cuivre.

8. Utilisation selon la revendication 7, **caractérisée en ce que** les cartes de circuits imprimés passent dans le sens horizontal dans une installation de traitement appropriée et y sont mises en contact avec les diverses solutions de traitement l'une après l'autre dans différentes positions de traitement.
